Europäisches Patentamt

European Patent Office

Office européen des brevets

(19)

(11) EP 0 787 683 B1

(12) FASCICULE DE BREVET EUROPEEN

(45) Date de publication et mention
de la délivrance du brevet:
**29.08.2001 Bulletin 2001/35**

(51) Int Cl.7: **C01B 21/076**, C23C 16/34,
C23C 14/06, C04B 41/87

(21) Numéro de dépôt: **97400217.2**

(22) Date de dépôt: **30.01.1997**

(54) **Nitrure de titane dopé par du bore, revêtement de substrat à base de ce nouveau composé et pièces comportant un tel revêtement**

Bordotiertes Titaniumnitrid, Beschichtung bestehend aus dieser neuen Verbindung eines Substrats und Körper mit einer solchen Beschichtung

Titanium nitride substituted with boron, coating based on this new compound of a substrate and shaped bodies comprising such a coating

(84) Etats contractants désignés:
**BE DE ES GB IT NL SE**

(30) Priorité: **01.02.1996 FR 9601229**

(43) Date de publication de la demande:
**06.08.1997 Bulletin 1997/32**

(73) Titulaire: **Tecmachine**
**42160 Andrézieux-Bouthéon (FR)**

(72) Inventeur: **Heau, Christophe**
**42100 Saint-Etienne (FR)**

(74) Mandataire: **CABINET BONNET-THIRION**
**12, Avenue de la Grande-Armée**
**75017 Paris (FR)**

(56) Documents cités:
EP-A- 0 149 044      EP-A- 0 685 297
WO-A-93/03195        US-A- 5 318 840

• CHEMICAL ABSTRACTS, vol. 120, no. 16, 18 Avril 1994 Columbus, Ohio, US; abstract no. 198322, GISSLER, W. ET AL: "Ti-B-N and Hf-B-N coatings prepared from multilayers and by co-sputtering" XP002017599 & SPEC. PUBL. - R. SOC. CHEM. (1993), 126(SURFACE ENGINEERING, VOL. I, FUNDAMENTAL OF COATINGS), 320-8 CODEN: SROCDO;ISSN: 0260-6291, 1993,

• CHEMICAL ABSTRACTS, vol. 120, no. 10, 7 Mars 1994 Columbus, Ohio, US; abstract no. 114418, FRIESEN, T. ET AL: "Hardness and Young's modulus of cosputtered titanium-boron-nitrogen and hafnium-boron-nitrogen films and correlations to their microstructure and composition" XP002017600 & NATO ASI SER., SER. E (1993), 233(MECHANICAL PROPERTIES AND DEFORMATION BEHAVIOR OF MATERIALS HAVING ULTRA-FINE MICROSTRUCTURES), 475-80 CODEN: NAESDI;ISSN: 0168-132X, 1993,

• CHEMICAL ABSTRACTS, vol. 80, no. 16, 22 Avril 1974 Columbus, Ohio, US; abstract no. 85194, TROITSKII, V. N. ET AL: "Preparation of titanium boronitride powders in superhigh-frequency discharge plasma" XP002017601 & POROSH. MET. (1973), (11), 6-9 CODEN: PMANAI, 1973,

• SURFACE AND COATINGS TECHNOLOGY, vol. 74-75, 1995, AMSTERDAM (NL), pages 491-496, XP000605840 T.P. MOLLART ET AL.: "Nanostructured titanium boron nitride coatings of very high hardness."

EP 0 787 683 B1

**EP 0 787 683 B1**

**Description**

La présente invention concerne un nouveau composé constitué par du nitrure de titane dopé par du bore. L'invention concerne plus particulièrement un nitrure de titane dopé par du bore, ayant une composition et une structure nouvelles présentant un ensemble de propriétés mécaniques remarquables, une dureté proche de celle du diamant, et en tout cas supérieure à 50 GPa dans l'échelle des duretés Vickers, une absence de fragilité et une résistance exceptionnelle à l'usure.

L'invention concerne aussi un revêtement de substrat à base de ce nitrure de titane dopé par du bore, possédant une dureté élevée et permettant une très bonne résistance à l'usure. L'invention concerne encore des pièces comportant un tel revêtement.

Pour les matériaux, telles des pièces mécaniques ou autres, devant résister à l'usure, la résistance à l'usure est fréquemment assurée grâce à la protection conférée par un revêtement. Dans un tel cas, il importe que le revêtement présente une très grande dureté mais que cette dureté ne soit pas obtenue au prix d'une fragilité trop importante qui affecterait la protection, par exemple en cas de choc mécanique ou thermique. Le revêtement doit en outre présenter une conductibilité thermique suffisante pour permettre une évacuation de l'énergie dissipée par le frottement. Le revêtement doit encore être compatible chimiquement et métallurgiquement avec le matériau constituant la pièce à revêtir de façon à y être parfaitement adhérent.

L'ensemble de ces propriétés est nécessaire par exemple dans le cas des outils de mise en forme des matériaux, par coupe, déformation, ou encore par moulage, qui représente un champ préférentiel, mais non limitatif, d'application de l'invention.

Il est aujourd'hui courant de revêtir les outils en acier ou en céramique de façon à améliorer leur résistance à l'usure et à améliorer ainsi leur performance. Les revêtements les plus utilisés sont les revêtements de nitrure de titane qui sont en général mis en oeuvre sur les outils par des techniques de dépôt physique ou chimique en phase vapeur. Plus récemment, et afin de dépasser les limitations d'application du nitrure de titane, notamment lorsque la température d'utilisation peut dépasser environ 450°C, des revêtements de carbonitrure de titane (TiCN), ou encore de nitrure mixte de titane et d'aluminium (TiAIN) ont été proposés. De même, d'autres nitrures d'éléments de transition tels que les combinaisons chrome/azote décrites dans le FR-A-2 653 452 ont été proposés avec succès.

L'ensemble des revêtements décrits ci-dessus - nitrures et carbonitrures d'éléments de transition - présente des duretés voisines comprises généralement entre 20 et 35 GPa. Ils sont généralement affectés de très fortes contraintes résiduelles qui ne permettent pas de les utiliser avec des épaisseurs de couches supérieures à 10 micromètres sans courir le risque d'une fragilité trop élevée, incompatible avec leur utilisation dans des conditions sévères.

A l'heure actuelle aucun revêtement ne permet de dépasser de façon significative le niveau de performances obtenu avec les matériaux décrits ci-dessus. Une solution qui pourrait être envisagée, réalisant un saut technologique important, serait d'utiliser des revêtements de diamant cristallin ou bien de nitrure de bore cubique mais, malheureusement, les difficultés de mise en oeuvre de telles dispositions ne semblent pas encore maîtrisées.

Un objet de la présente invention est de réaliser un gain de performance significatif par rapport aux revêtements de nitrure de titane qui constituent aujourd'hui une référence en la matière pour l'amélioration de la résistance à l'usure de pièces mécaniques, notamment des outils.

A cet effet, il faut disposer d'un matériau présentant au moins les propriétés mécaniques suivantes :

- dureté très élevée, d'au moins 50 GPa
- bonne conductibilité thermique
- absence de fragilité
- contraintes internes modérées

Or il a été considéré jusqu'à présent comme peu probable d'obtenir, à la fois et sur un même matériau, ces quatre propriétés. En effet, la dureté très élevée est obtenue pour les matériaux présentant des liaisons chimiques de type covalent, mais ce type de liaison conduit à une fragilité rédhibitoire, c'est le cas rencontré avec certaines céramiques.

La conductibilité thermique et l'absence de fragilité sont généralement le fait des solides présentant des liaisons de type ionique; c'est le cas des métaux et alliages, c'est aussi le cas des nitrures de chrome ou de titane déjà cités, mais en raison de la nature même de ces liaisons, la dureté ne dépasse jamais environ 10 GPa pour les alliages les plus durs et 35 GPa environ pour les combinaisons métal/azote.

De façon tout à fait imprévue, la demanderesse a découvert que le dopage d'un nitrure, tel que le nitrure de titane, avec un élément tel que le bore, pouvait lui conférer une dureté exceptionnelle, supérieure à 50 GPa sans affecter sa conductibilité thermique et sans le rendre fragile. De la sorte, la demanderesse a pu montrer que la résistance à l'usure d'un tel matériau dopé par du bore était améliorée dans de très grandes proportions par rapport à celles du même matériau non dopé; typiquement, ce gain représente un facteur pouvant aller de 5 à 10.

Il s'agit bien d'un matériau dopé et non d'une nouvelle phase car si on procède à une analyse de phase par une technique appropriée sur des revêtements conformes à l'invention, seul le nitrure de titane TiN (osbornite) apparaît, à l'exception de toute phase ou composé défini contenant du bore. De plus, au plan structurel, cette combinaison n'est pas un boronitrure proprement dit car de tels matériaux sont fragiles, mais elle présente la structure métallurgique du nitrure de titane TiN dans lequel le bore est soit en insertion soit en substitution, de sorte qu'il s'agit en fait d'un "nitrure de titane dopé par du bore". Le nouveau matériau de l'invention est monophasé, c'est-à-dire, il comporte une seule phase métallurgique.

D'une façon générale, un matériau doit être défini par un ensemble de caractéristiques dont découleront les propriétés utiles telles que dureté, résistance aux chocs, à l'usure, résistivité, etc.

La caractéristique de base à prendre en considération est principalement la nature de la phase ou des phases présente(s) car elle définit l'arrangement des atomes les uns par rapport aux autres. La technique la plus courante pour l'identification de phases est la diffraction des rayons X qui est d'autant plus sensible que les phases sont bien cristallisées. Cette technique est en revanche peu sensible lorsque les phases sont microcristallines. Les phases nanocristallines peuvent même passer totalement inaperçues, ainsi que les phases amorphes. D'autres techniques peuvent alors être utilisées, les plus courantes étant la diffraction des électrons et la spectrométrie Raman.

De nombreux matériaux contenant du titane, de l'azote et du bore ont été décrits dans l'art antérieur. La Demanderesse peut citer à cet égard les travaux de W. Gissler, T. Friesen, J. Haupt et D. G. Rickerby dans R. Soc. Chem. (1993), 126 (Surface Engineering, vol. I, Fundamental of Coatings) résumés dans Chemical Abstracts, vol. 120, no. 16, 18 avril 1994, qu'elle a étudiés. Cette publication décrit un composé TiNx(By) qui comporte, en sus de la phase cristalline, une phase amorphe, c'est-à-dire du nitrure de titane dans une matrice vitreuse. Le composé décrit dans cette publication est un matériau polyphasé contrairement à celui de la présente invention qui est monophasé. La Demanderesse a en outre déterminé que le matériau de cette publication se situait dans une zone à la fois de haute dureté et de très grande fragilité (déterminée au "scratch test" [test de la rayure]).

La publication "Nanostructured titanium boron nitride coatings of very high hardness", T.P. Mollart et al., Surface and Coating Technology 74-75 (1995), pages 491-496, décrit des composés à base de Ti, B et N qui semblent présenter une structure du type TiBN.

La Demanderesse a aussi étudié d'autres travaux de Gissler dans la publication de T. Friesen, J. Haupt, P. N. Gibson et W. Gissler, NATO ASI SER., SER. E (1993), 233 (Mechanical Properties and Deformation Behavior of Materials Having Ultra-Fine Microstructures), résumée dans Chemical Abstracts, vol. 120, no. 10, 7 mars 1994. La diffraction des rayons X pratiquée sur les dépôts de composés de cette publication fait apparaître une structure cristalline du type AlB$_2$ qui n'a rien à voir avec le nitrure de titane dopé par du bore de la présente invention. De même que pour le composé de la publication précédemment analysée, le matériau de cette publication se situe dans une zone à la fois de haute dureté et de grande fragilité.

La Demanderesse peut également citer la publication de V. N. Troitskii et al. "Preparation of Titanium Boronitride Powders in Superhigh-Frequency Discharge Plasma", résumée dans Chemical Abstracts, vol. 80, no. 16, 22 avril 1974. Le matériau décrit dans cette publication est une solution solide, et non une phase. Le réseau cristallin est dans ce cas celui du titane, plus ou moins déformé par des inclusions de bore ou d'azote, alors que dans la présente invention, c'est le réseau cristallin de la phase TiN qui est présent, le bore se trouvant probablement en insertion. La solution solide de la publication de Troitskii et al. est sursaturée et métastable car un recuit fait précipiter les phases BN et B, conduisant à un matériau polyphasé très éloigné de celui de la présente invention. Le matériau de l'invention est une céramique alors que celui de Troitskii et al. a les propriétés d'un métal.

Bien que l'obtention de l'ensemble de propriétés tout à fait remarquables du nouveau matériau de l'invention n'ait pas encore été expliquée, on peut penser, sans vouloir cependant être lié par une quelconque théorie, que l'atome de bore, de très petite taille, peut se fixer dans la maille du nitrure de titane TiN (osbornite), soit à la place d'un atome d'azote (TiN présente généralement des défauts de stoechiométrie dus à des lacunes d'azote ou de titane), soit en position intersticielle. Il bloquerait ainsi les possibilités de déformation du réseau cristallin, augmentant la dureté du matériau, sans affecter ses autres propriétés.

La présente invention fournit donc un nitrure de titane dopé par du bore, cristallisant dans la même structure que le nitrure de titane TiN, et ayant une microdureté Vickers supérieure à environ 50 Gpa, et caractérisé par le fait que ses proportions, exprimées en pourcentages atomiques, entre ses trois constituants, azote, titane et bore, sont liées par les relations

4 % < B < 28 %

18%<N<34%

Ti = complément à 100 %

De façon préférentielle, les pourcentages atomiques des constituants azote, titane et bore du nitrure de titane dopé par du bore de l'invention sont dans des proportions telles que

$$\frac{B + N}{Ti} = 0,75$$

Il faut noter que la structure métallurgique de ce nouveau composé de nitrure de titane dopé par du bore est celle du nitrure de titane TiN dans lequel le bore se trouve en insertion ou en substitution, en particulier il n'apparaît pas de phases du type borure de titane ou boronitrure de titane.

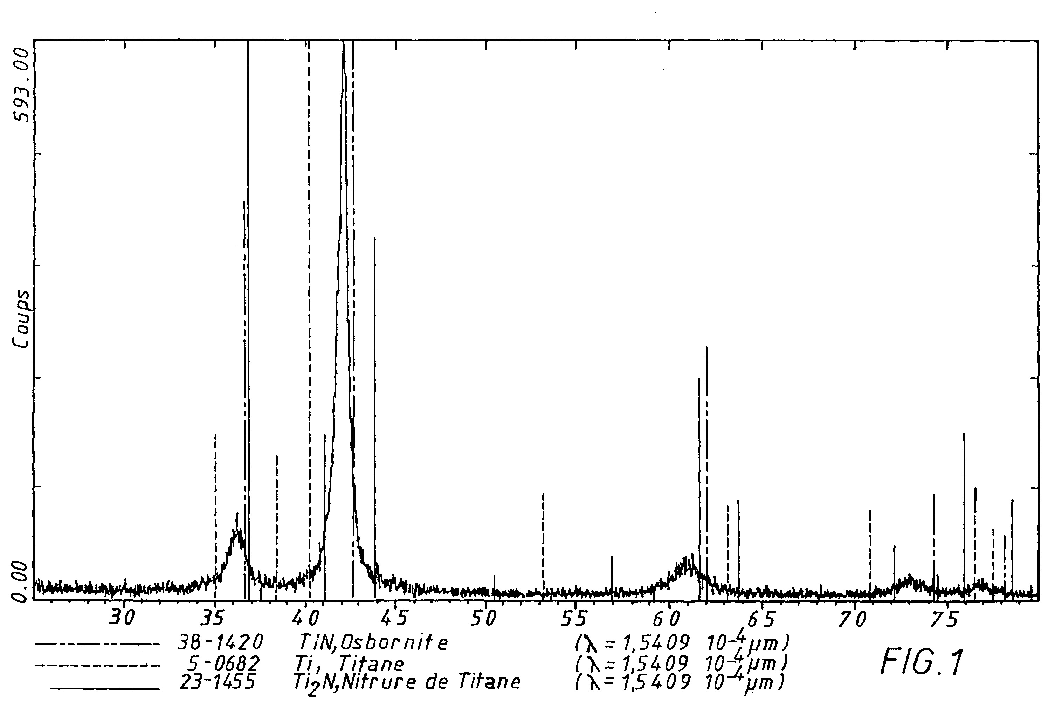

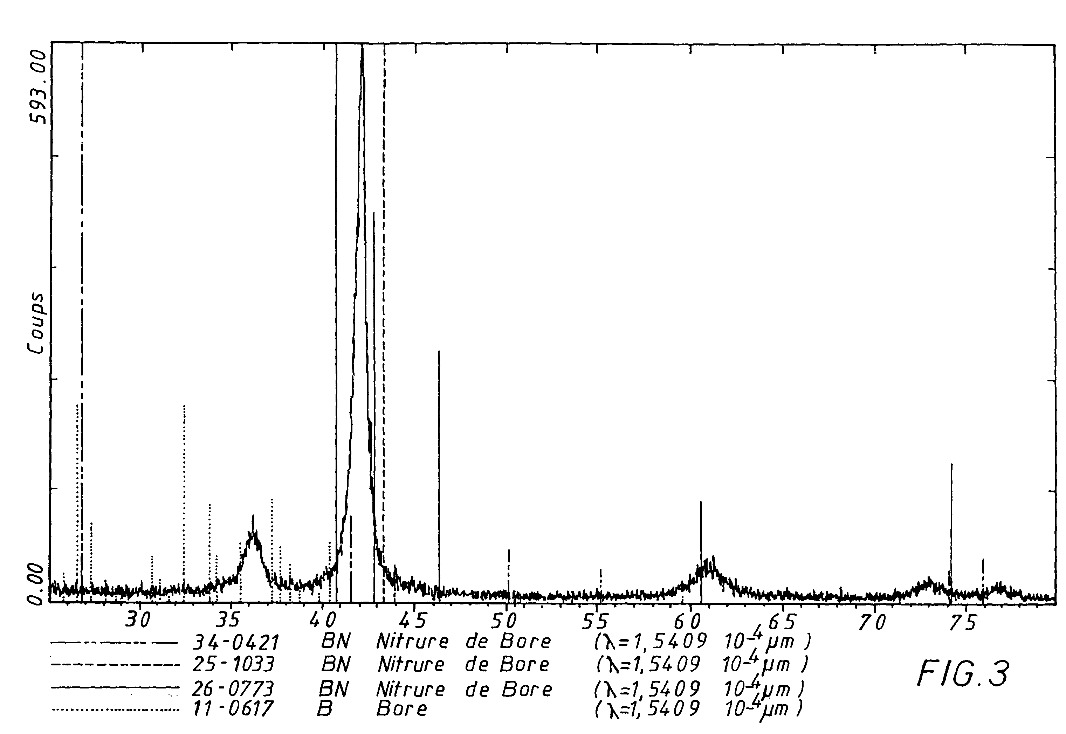

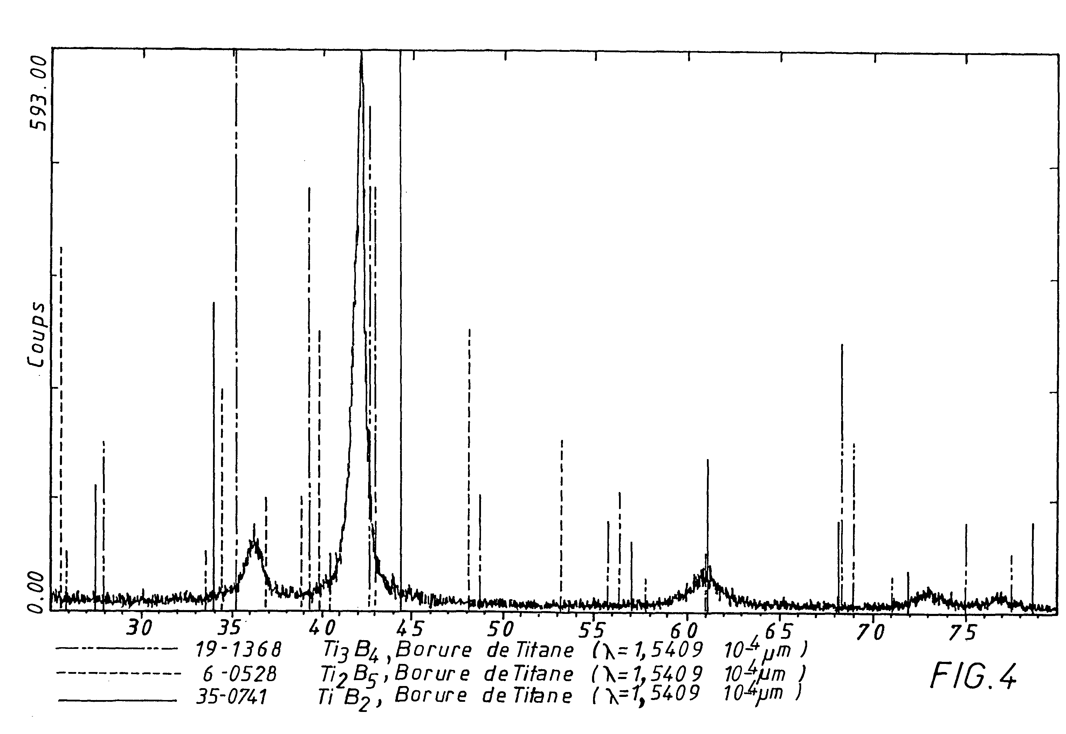

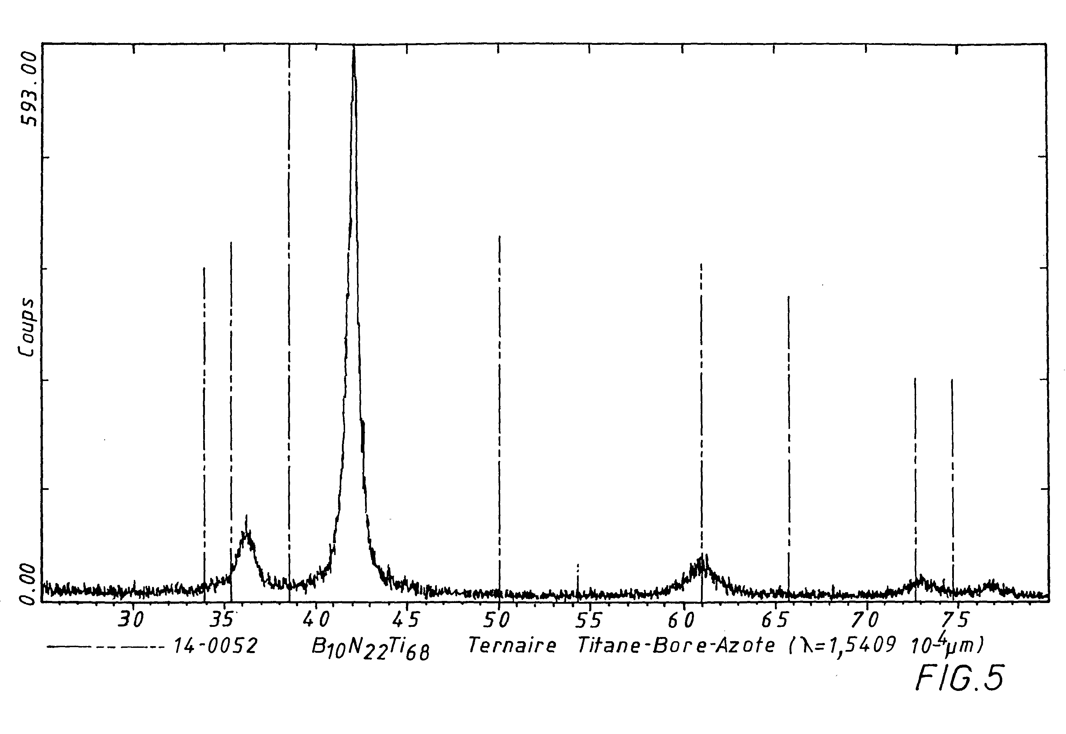

La structure métallurgique du nouveau composé de la présente invention apparaîtra plus clairement à l'examen des Figures 1 à 5 annexées.

Les Figures 1 à 5 représentent chacune un spectre de diffraction des rayons X d'un même nitrure de titane dopé par du bore de la présente invention, avec les indexations des pics théoriques de différentes phases Ti-N, Ti-B, B-N ainsi que les pics théoriques d'une phase TiBN (boronitrure de titane).

Pour chacune des Figures,

- l'axe vertical (gradué de 0 à 593) correspond à l'intensité des rayons X;
- l'axe horizontal (gradué de 25 à 80°) correspond aux angles 2 θ balayés en degrés;
- les conditions étaient les suivantes : CT = 11,2 $s^{-1}$ (correspondant à un nombre de coups de 11,2 par seconde); SS = 0,020 dg (correspondant au pas d'angle d'analyse gradué en θ); λ = 1,5409 $10^{-4}$ μm correspond à une longueur d'onde λ de 1,5409 $10^{-4}$ μm qui est celle de la raie K$\alpha_1$ d'émission du cuivre;
- les nombres mis avant les composés indexés correspondent aux numéros ASTM.

La Figure 1 représente un spectre de diffraction des rayons X d'un nitrure de titane dopé par du bore de la présente invention avec les indexations des pics théoriques des phases de nitrure de titane TiN, osbornite, Ti, titane et $Ti_2N$, nitrure de titane.

La Figure 2 représente un spectre de diffraction des rayons X d'un nitrure de titane dopé au bore de la présente invention avec les indexations des pics théoriques des phases Ti, titane, $TiB_2$, borure de titane et TiB, borure de titane.

La Figure 3 représente un spectre de diffraction des rayons X d'un nitrure de titane dopé au bore de la présente invention avec les indexations des pics théoriques des phases BN, nitrure de bore, BN, nitrure de bore, BN, nitrure de bore, et B, bore.

La Figure 4 représente un spectre de diffraction des rayons X d'un nitrure de titane dopé par du bore de la présente invention avec les indexations des pics théoriques des phases $Ti_3B_4$, borure de titane, $Ti_2B_5$, borure de titane et $TiB_2$, borure de titane.

La Figure 5 représente un spectre de diffraction des rayons X d'un nitrure de titane dopé au bore de la présente invention avec les indexations des pics théoriques d'une phase ternaire Ti-B-N (boronitrure de titane), la phase $B_{10}N_{22}Ti_{68}$.

L'examen de la Figure 1 montre que la phase de nitrure de titane TiN (osbomite) se retrouve dans le nouveau composé de la présente invention, et que la phase de titane ne s'y retrouve pas.

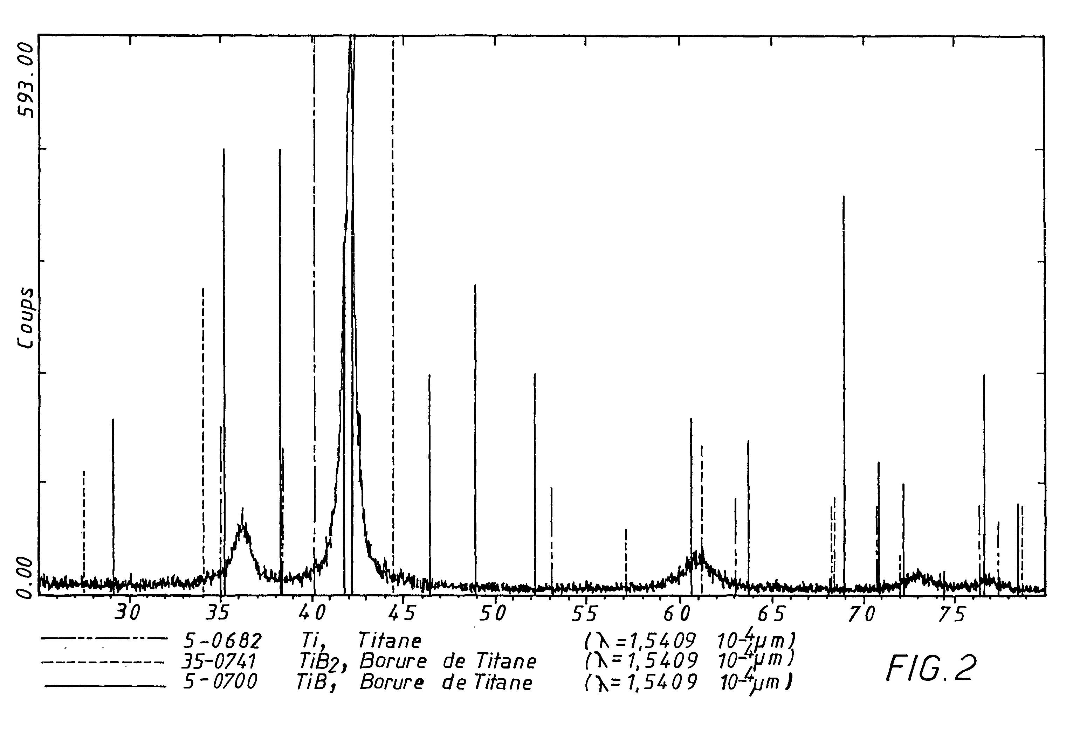

L'examen des Figures 2 à 5 montre en outre que les phases de borure de titane TiB, de borure de titane $TiB_2$, de borure de titane, $Ti_3B_4$, de borure de titane, $Ti_2B_5$, de nitrure de bore BN, de titane Ti, de bore et de ternaire Ti-B-N boronitrure de titane, $B_{10}N_{22}Ti_{68}$, ne se retrouvent pas dans le nouveau composé de la présente invention.

La présente invention fournit également un revêtement antiusure caractérisé par le fait qu'il est constitué par un composé tel que défini ci-dessus. Le revêtement selon la présente invention a de préférence une épaisseur supérieure à environ 1 μm.

Le matériau objet de l'invention est avantageusement mis en oeuvre sous forme d'un revêtement déposé par une technologie appropriée sur la pièce qu'il doit protéger.

La mise en oeuvre de ces revêtements peut être faite par tout moyen approprié; les technologies de dépôt sous vide et plus particulièrement la pulvérisation cathodique, constituent un moyen privilégié permettant de réaliser des couches dont l'épaisseur, fonction de l'application envisagée, peut atteindre plusieurs dizaines de micromètres. On peut, par exemple, vaporiser un composé titane-bore dans une atmosphère raréfiée contenant de l'azote. Quand on vaporise un tel composé Ti-B, la vapeur est atomique, presque toujours monoatomique, et contient des atomes de Ti, des atomes de B et des atomes de N. Le titane s'associe à l'azote et le bore vient s'insérer dans le nitrure de titane formé.

Selon la présente invention, les revêtements peuvent être appliqués aussi bien sur des pièces métalliques, en alliages ferreux ou autres, que sur des pièces en céramique comme du carbure de tungstène ou des cermets, par exemple.

L'invention sera à présent décrite plus en détail dans les exemples non limitatifs ci-après.

Exemple 1

On dépose sur une plaquette en acier au carbone de dimensions 36 mm x 18 mm x 8 mm, une couche de nitrure de titane dopé par du bore conforme à l'invention d'une épaisseur de 10 micromètres. Pour cela, on place cette plaquette dans une machine de dépôt par pulvérisation cathodique magnétron équipée d'une cible à base d'un composé bore-titane que l'on pulvérise dans une atmosphère d'argon et d'azote sous pression réduite. Les conditions opératoires sont les suivantes :

- Pression partielle d'argon : 2,2 Pa

- Pression partielle d'azote : 0,05 Pa

- Puissance cathodique : 1,8 kW

- Durée de traitement : 60 minutes

On procède sur cette pièce revêtue aux caractérisations habituellement pratiquées pour évaluer ce type de matériaux, soit :

- Analyse chimique élémentaire par "glow discharge spectrometry" (spectrométrie à décharge luminescente)
- Mesure de dureté superficielle par microindentation Vickers
- Scarification superficielle selon le test habituel connu sous le nom de "scratch test" (essai de rayure) permettant de mesurer à la fois l'adhérence et la fragilité du revêtement; le résultat est qualifié par la charge pour laquelle apparaissent des phénomènes d'écaillages.
- Résistance à l'usure obtenue en faisant frotter sur cette plaquette une bague abrasive chargée en carbure de silicium. La vitesse linéaire est de 0,55 m/s, la charge appliquée est de 5 daN et la durée de l'essai est de 10 minutes. L'essai est pratiqué dans l'eau afin d'évacuer la chaleur produite par le frottement et le résultat est exprimé sous forme de la vitesse d'usure en micromètres par minute.

On a choisi comme référence un revêtement de nitrure de titane réalisé par dépôt physique en phase vapeur; le Tableau 1 ci-après illustre et compare les résultats.

Tableau 1

|  | Nitrure de titane dopé par du bore selon la présente invention | Nitrure de titane pur |
|---|---|---|
| Composition chimique | Ti 56 %<br>B 22 %<br>N 22 % | Ti 50 %<br>N 50 % |
| Microdureté | 70 GPa | 25 GPa |
| Charge critique essai de rayure (scratch test) | 42 N | 40 N |
| Vitesse d'usure | 0,04 µm/mn | 0,41 µm/mn |

Le dopage par du bore a bien permis de conserver la ductilité initiale du nitrure de titane, tout en augmentant considérablement sa dureté (facteur 2,8) et sa résistance à l'usure (facteur 10 environ).

Exemple 2

On procède comme dans l'Exemple 1, mais on compare le revêtement de nitrure de titane dopé par du bore conforme à l'invention à quatre autres revêtements réalisés également par dépôt sous vide mais dont la composition n'est pas conforme à l'invention.

Les résultats des caractérisations sont rassemblés dans le Tableau 2 ci-après.

Tableau 2

|  | Dépôt conforme à l'invention | Dépôt non conforme n° □1 | Dépôt non conforme n° □2 | Dépôt non conforme n° □3 | Dépôt non conforme n° □4 |
|---|---|---|---|---|---|
| Composition chimique | Ti 56 %<br><br>B 22 %<br>N 22 % | Ti 38 %<br><br>B 56%<br>N 6 % | Ti 26 %<br><br>B 38%<br>N 36 % | Ti 56 %<br><br>B 28 %<br>N 16% | Ti 80 %<br><br>B 10%<br>N 10% |
| Microdureté | 70 GPa | 55 GPa | 42 GPa | 50 GPa | 38 GPa |
| Charge critique | 42 N | 38 N | 36 N | 36 N | 24 N |
| Vitesse d'usure | 0,04 µm/mn | 30 µm/mn | 0,32 µm/mn | 0,10 µm/mn | 7,9 µm/mn |

Les quatre revêtements non conformes à l'invention sont également très durs mais ils ont une résistance à l'usure nettement moins bonne que celui conforme à l'invention .

**Revendications**

1.  Nitrure de titane dopé par du bore, cristallisant dans la même structure que le nitrure de titane TiN, et ayant une microdureté Vickers supérieure à environ 50 GPa, caractérisé par le fait que les proportions, exprimées en pourcentages atomiques, entre ses trois constituants, azote, titane et bore, sont liées par les relations

     4 % < B < 28 %
     18 % < N < 34 %
     Ti = complément à 100 %

2.  Nitrure de titane dopé par du bore selon la revendication 1, caractérisé par le fait que les pourcentages atomiques de ses constituants azote, titane et bore sont dans des proportions telles que

$$\frac{B + N}{Ti} = 0,75$$

3.  Nitrure de titane dopé par du bore selon l'une des revendications 1 et 2, **caractérisé en ce qu**'il comporte une seule phase métallurgique.

4.  Revêtement antiusure caractérisé par le fait qu'il est constitué d'un composé selon l'une quelconque des revendications 1 à 3.

5.  Revêtement selon la revendication 4, caractérisé par le fait qu'il a une épaisseur supérieure à environ 1 µm.

6.  Pièce comportant un revêtement selon l'une des revendications 4 et 5.

7.  Pièce selon la revendication 6, caractérisée par le fait qu'elle est choisie parmi les pièces métalliques, les pièces en carbure de tungstène et les pièces en cermets.

8.  Procédé d'application d'un revêtement selon l'une des revendications 4 et 5, par une technologie de dépôt sous vide.

9.  Procédé selon la revendication 8, dans lequel la technologie de dépôt sous vide est la pulvérisation cathodique.

10. Procédé selon la revendication 8, dans lequel on vaporise un composé titane-bore dans une atmosphère raréfiée contenant de l'azote.

**EP 0 787 683 B1**

**Patentansprüche**

1. Bor dotiertes Titannitrid, das in der gleichen Struktur kristallisiert wie Titannitrid und eine Vickers-Microhärte über etwa 50 GPa hat, **dadurch gekennzeichnet**, daß die Verhältnisse der drei Bestandteile Stickstoff, Titan und Bor, ausgedrückt in Atomprozenten, durch die folgenden Zusammenhänge gebunden sind

    4 % < B < 28 %
    18% < N < 34 %
    Ti = Rest auf 100 %

2. Bor dotiertes Titannitrid nach Anspruch 1, gekennzeichnet durch die Tatsache, daß die Atomprozentsätze seiner Bestandteile Stickstoff, Titan und Bor in Verhältnissen wie

$$\frac{B + N}{Ti} = 0{,}75$$

    liegen.

3. Bor dotiertes Titannitrid nach einem der Ansprüche 1 und 2, **dadurch gekennzeichnet**, daß es eine einzige metallurgische Phase hat.

4. Verschleißfester Überzug, gekennzeichnet durch die Tatsache, daß er aus einer Verbindung nach einem der Ansprüche 1 bis 3 besteht.

5. Überzug nach Anspruch 4, **dadurch gekennzeichnet**, daß er eine Dicke über etwa 1 μm hat.

6. Werkstück enthaltend einen Überzug nach einem der Ansprüche 4 und 5.

7. Werkstück nach Anspruch 6, **dadurch gekennzeichnet**, daß es aus metallischen Werkstücken, Wolframcarbid- und metallkeramischen Bauteilen besteht.

8. Verfahren zum Aufbringen eines Überzugs nach einem der Ansprüche 4 und 5 durch eine Vakuumabscheidungstechnologie.

9. Verfahren nach Anspruch 8, bei dem die Vakuumabscheidungstechnologie eine Katodenzerstäubung ist.

10. Verfahren nach Anspruch 8, bei dem man eine Titan-Bor-Verbindung in einer verdünnten Atmosphäre verdampft, die Stickstoff enthält.


**Claims**

1. Boron-doped titanium nitride which crystallises in the same structure as titanium nitride TiN and being of a Vickers microhardness of greater than about 50 GPa, **characterised in that** the proportions expressed as atomic percentages among its three constituents, nitrogen, titanium and boron, are linked by the following relationships:

    4%<B<28%
    18%<N<34%
    Ti = make-up amount to 100%.

2. Boron-doped titanium nitride according to claim 1 **characterised in that** the atomic percentages of its constituents, nitrogen, titanium and boron are in proportions such that:

$$\frac{B+N}{Ti} = 0.75$$

3. Boron-doped titanium nitride according to one of claims 1 and 2 **characterised in that** it comprises a single metallurgical phase.

7

4.  An anti-wear coating **characterised in that** it is formed by a compound according to any one of claims 1 to 3.

5.  A coating according to claim 4 **characterised in that** it is of a thickness of greater than about 1 μm.

6.  A component comprising a coating according to one of claims 4 and 5.

7.  A component according to claim 6 **characterised in that** it is selected from metal components, components of tungsten carbide and components of cermets.

8.  A process for applying a coating according to one of claims 4 and 5 by vacuum deposition technology.

9.  A process according to claim 8 wherein the vacuum deposition technology is cathodic sputtering.

10. A process according to claim 8 wherein a titanium-boron compound is vaporised in a rarefied atmosphere containing nitrogen.

FIG.1

38-1420    TiN,Osbornite      ($\lambda = 1,5409 \; 10^{-4} \mu m$)
5-0682    Ti, Titane      ($\lambda = 1,5409 \; 10^{-4} \mu m$)
23-1455    Ti$_2$N,Nitrure de Titane      ($\lambda = 1,5409 \; 10^{-4} \mu m$)

EP 0 787 683 B1

Coups

593.00

0.00

30    35    40    45    50    55    60    65    70    75

| ―――――――― | 5-0682 | Ti, Titane | (λ =1,5409 10⁻⁴μm) |
| ―――――――― | 35-0741 | TiB₂, Borure de Titane | (λ =1,5409 10⁻⁴μm) |
| ―――――――― | 5-0700 | TiB, Borure de Titane | (λ =1,5409 10⁻⁴μm) |

FIG.2

FIG.3

FIG.4

14-0052 — $B_{10}N_{22}Ti_{68}$ — Ternaire Titane-Bore-Azote ($\lambda = 1,5409 \ 10^{-4} \mu m$)

FIG.5